# EUROPEAN PATENT APPLICATION

(11) **EP 4 543 151 A1**
(43) Date of publication of application: **23.04.2025**
(21) Application number: 24207090.2
(22) Date of filing: 17.10.2024
(51) Int. Cl.: H05K 7/14

(54) **A CABLE CARRIER FOR A POWER SYSTEM**

(30) Priority: 17.10.2023 IN 202321070763
(71) Applicant: Vertiv Corporation, Westerville, OH 43082 (US)
(72) Inventor: SAM, Yahya, Arsta (SE); SINGH, Balar Rampati, Sant Kabir Nagar (IN)
(74) Representative: Beal, James Michael

(57) **Abstract**

A cable carrier may include a frame, a first leg extending from a first end of the frame, and a second leg extending from a second end of the frame opposite the first end. The cable carrier may also include a first bracket mounted on a first flange of the first leg, and a second bracket mounted on a second flange of the second leg. A first surface of the frame may include at least one channel configured to guide at least one cable.

## Description

### CROSS REFERENCE TO RELATED APPLICATIONS

This U.S. Non-Provisional Patent Application claims the benefit of Indian Provisional Patent Application Serial No. 202321070763 titled "A Cable Carrier For A Power System" filed October 17, 2023.

### TECHNICAL FIELD

The present disclosure relates to cable installation and management in an equipment rackor enclosure.

### BACKGROUND

The background information herein below relates to the present disclosure but is not necessarily prior art.

Typically, in a server room or a data center, a large number of power systems are arranged in a rack or a shelf. These power systems are stacked and securely fastened together using pairs of mounting means, one on each side. These mounting means also serve to firmly attach a cable guide thereon. Additionally, each power system is configured with at least one cabinet where electronic components like controllers an electro-mechanical devices like a circuit breaker or any electrical device can be easily inserted and removed as per functionality of the power system. The controller or any other electro-mechanical device and the power system are configured with a plurality of ports in front as well as in rear which facilitate connectivity through an extensive network of cables.

Traditionally, the cables emerging from various ports, whether from the controller interface port or from the circuit breakers or any other device from the power system, are guided and affixed to the cable guide using multiple sealing tags. Consequently, when there is a need to replace the controller or any other electronic components (such as the circuit breaker) from the cabinets of the power system, it becomes tedious to do so without detaching the cable guide.

Further, removing the controller or any other electronic components from the power system can necessitate shutting down the power system, breaking the seal tags, unplugging the cables from the ports, and/or disassembling the cable guide from its mounting means. This process is time-consuming and labor-intensive, resulting in increased system downtime. Additionally, assembling the conventional cable guide can be inconvenient and challenging, especially when reconfiguring the cables on the cable guider.

Furthermore, it is essential to maintain the integrity of the cables during their routing through or over the cable guide. However, frequent assembly and disassembly of the conventional guide on the mounting means can lead to cable bending or kinking beyond the allowable minimum bend radius, potentially causing permanent damage to the cables and affecting their performance.

Therefore, there is a need of a cable carrier for a power system that alleviates the aforementioned drawbacks.

### SUMMARY

An aspect of the disclosed embodiments includes a cable carrier. The cable carrier may include: a frame, a first leg extending from a first end of the frame, and a second leg extending from a second end of the frame opposite the first end. The cable carrier may also include a first bracket mounted on a first flange of the first leg, and a second bracket mounted on a second flange of the second leg. A first surface of the frame may include at least one channel configured to guide at least one cable.

In some embodiments, the first leg extends in a first direction from the first end.

In some embodiments, the second leg extends in the first direction from the second end.

In some embodiments, the first leg, the second leg, and the frame define a u-shaped configuration.

In some embodiments, the first surface of the frame includes a plurality of clips disposed thereon, the plurality of clips being configured to retain at least the at least one cable.

In some embodiments, a first surface of the first leg includes at least one channel configured to guide at least one of the at least one cable or at least one other cable.

In some embodiments, the first surface of the first leg is adjacent to the first surface of the frame.

In some embodiments, the first surface of the first leg includes a plurality of clips disposed thereon, the plurality of clips being configured to retain at least one of the at least one cable and the at least one other cable.

In some embodiments, a first surface of the second leg includes at least one channel configured to guide at least one of the at least one cable or at least one other cable.

In some embodiments, the first surface of the second leg is adjacent to the first surface of the frame and faces the first surface of the first leg.

In some embodiments, the first surface of the second leg includes a plurality of clips disposed thereon, the plurality of clips being configured to retain at least one of the at least one cable and the at least one other cable.

In some embodiments, the frame is configured to pivot about a common axis of the first bracket and the second bracket.

In some embodiments, the frame is configured to lock at an angle relative to the first bracket and the second bracket.

### BRIEF DESCRIPTION OF THE ACCOMPANYING DRAWING

A cable carrier for a power system, of the present disclosure will now be described with the help of the accompanying drawing in which:
FIG. 1 illustrates a traditional arrangement (prior art) for mounting a plurality of cables on a power system arranged on a shelf or a rack.
FIG.2 illustrates a traditional cable guider arrangement (prior art) for routing and mounting cables on a power system.
FIG. 3 illustrates an arrangement of a cable carrier mounted on a power system for routing and mounting cables in accordance with the present disclosure.
FIG.4a illustrates an exploded view of the cable carrier in accordance with an embodiment of the present disclosure.
FIG.4b illustrates an arrangement for swiveling of a frame of the cable carrier in accordance with an embodiment of the present disclosure.
FIG. 5 illustrates the upward swiveling of the frame of the cable carrier while assembling or disassembling the electronic component within the cabinet of the power system in accordance with an embodiment of the present disclosure.
FIG. 6 illustrates the upward and downward swiveling of the frame of the cable carrier while assembling or disassembling the at least one electronic component within the cabinet of the power system in accordance with an embodiment of the present disclosure.
FIG.7 illustrates the routing and mounting of cables on the frame of the cable carrier in accordance with an embodiment of the present disclosure.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be described herein in detail.

It may be understood that the example embodiments described herein may be considered in a descriptive sense only and not for purposes of limitation. Descriptions of features or aspects within each example embodiment may be considered as available for other similar features or aspects in other example embodiments.

In some embodiments, the systems and methods described herein may be configured to provide a cable carrier for a power system. The cable carrier may be configured to guide a cable effectively without causing bending or kinking of the cable. The cable carrier may be configured to facilitate swiveling of the frame of the cable carrier during assembling or disassembling of at least one electronic component into or from the power system. The cable carrier may be configured to reduce the power system shut down time. The cable carrier may be configured to reduce assembling and disassembling time of at least one electronic component into or from the power system. The cable carrier may be configured to simplify maintenance and can enhance serviceability. The cable carrier may be configured to prolong the cable life. The cable carrier may be configured to be assembled with the existing power system. The cable carrier may be configured to be easy to handle. The cable carrier may be configured to facilitate ease of access of the cabinet of the power system. The cable carrier may be configured to be easy to assemble.

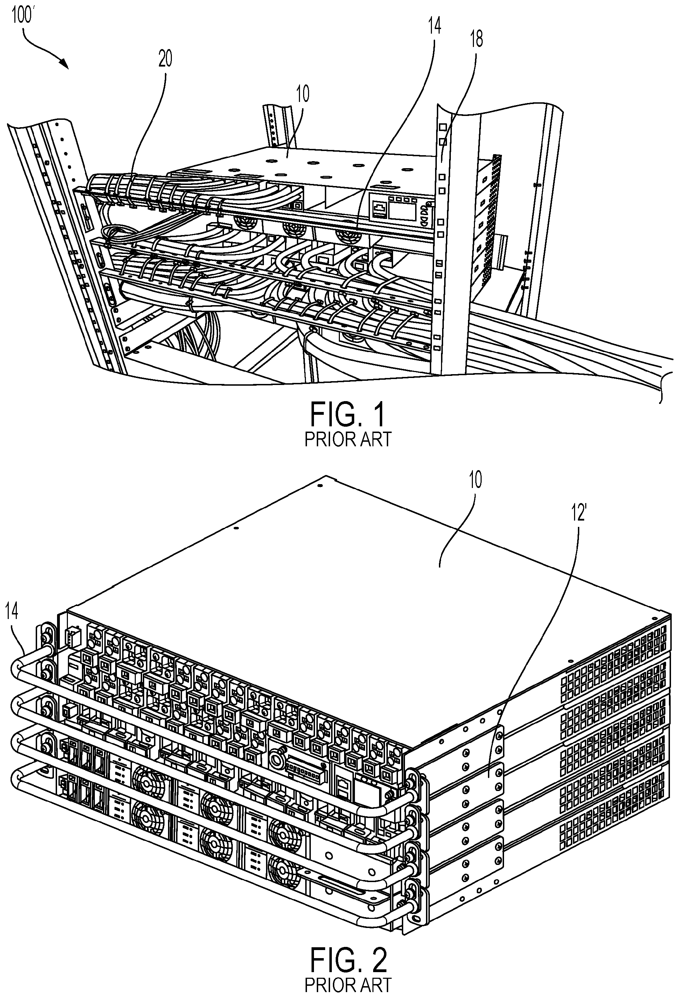

Typically, a power system 10 interface is configured with a plurality of ports in frontas well as in rear which facilitate connectivity through an extensive network of cables. The cables emerging from various ports, are guided and affixed to the cable guide using multiple sealing tags 20. FIG. 1 illustrates a traditional arrangement 100' for mounting a plurality of cables on a power system arranged on a shelf 18 or a rack 18. Consequently, when there is a need to replace the controller or any other electronic components 22 (e.g., such as the circuit breaker) from the cabinet of the power system 10,it becomes tedious to do so without detaching the cable guide.

Further, removing the controller 22 or any other electronic components from the power system 10 can necessitate shutting down the power system 10, breaking the seal tags, unplugging the cables from the ports, and/or disassembling the cable guide from its mounting means. This process is time-consuming and labor-intensive, resulting in increased system downtime. Additionally, assembling the conventional cable guide can be inconvenient and challenging, especially when reconfiguring the cables on it. FIG. 2 illustrates a traditional cable guider arrangement for routing and mounting cables on a plurality of power systems.

Furthermore, it can be essential to maintain the integrity of the cables during their routing through or over the cable guide. However, frequent assembly and disassembly of the conventional guide on the mounting means 12' can lead to cable bending or kinking beyond the allowable minimum bend radius, potentially causing permanent damage to the cables and affecting their performance.

Therefore, the present disclosure envisages a cable carrier 16 (herein after referred as carrier 16) for routing and mounting cables with respect to the power system 10. The carrier 16 may be configured to guide the cable effectively without causing bending or kinking of the cable.

The carrier 16 may be configured to facilitate swiveling of the frame of the carrier 16 during assembling or disassembling of at least one electronic component in the power system 10. The carrier 16 may be configured to reduce the power system 10 shut down time. The carrier 16 may be configured to reduce assembling and disassembling time of at least one electronic component in the power system 10. The carrier 16 may be configured to simplify maintenance and can enhance serviceability. The carrier 16 may be configured to reduce system downtime.

The carrier 16 may be configured to prolong the cable life. The carrier 16 may be configured to be assembled on the existing power system. The carrier 16 may be configured to be easy to handle. The carrier 16 may be configured to facilitate ease of access of the cabinet of the power system. The carrier 16 may be configured to be easy to assemble.

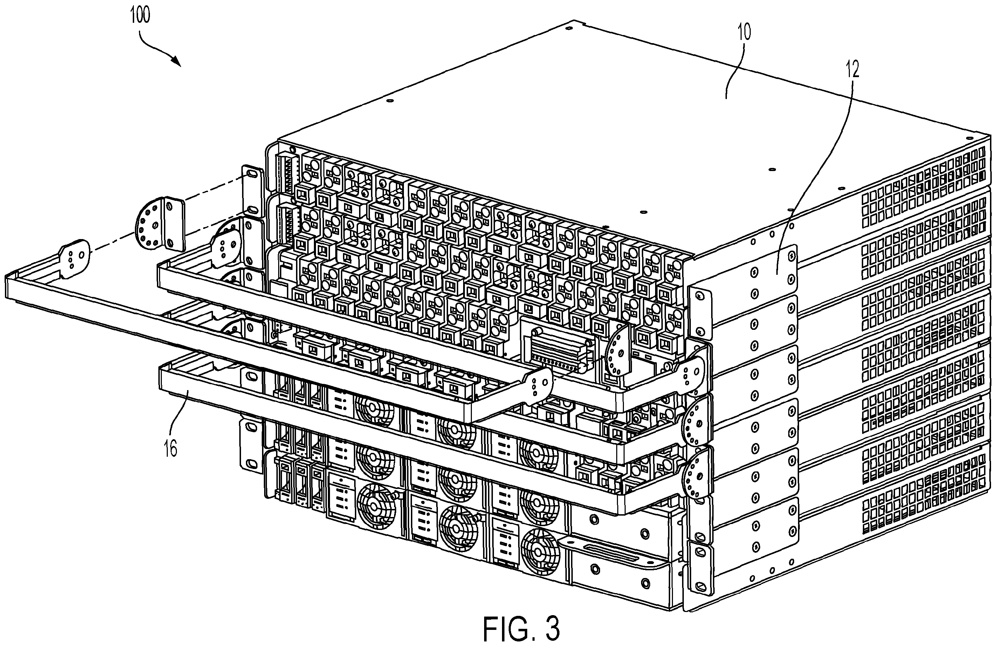

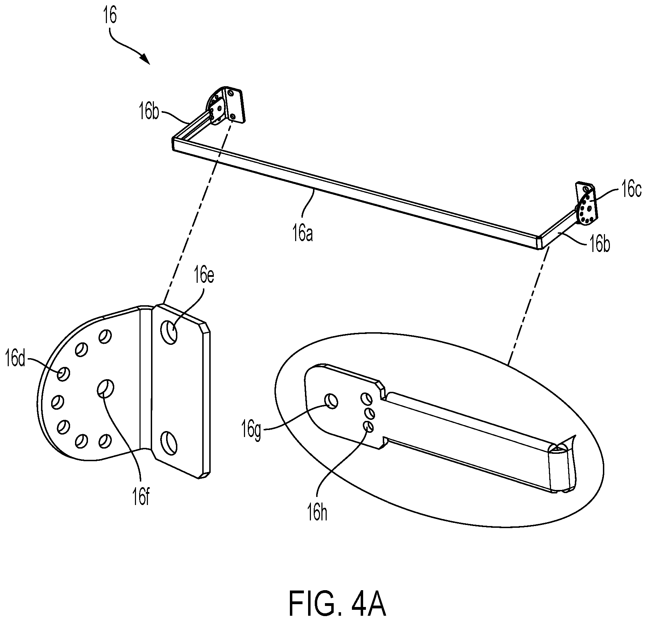

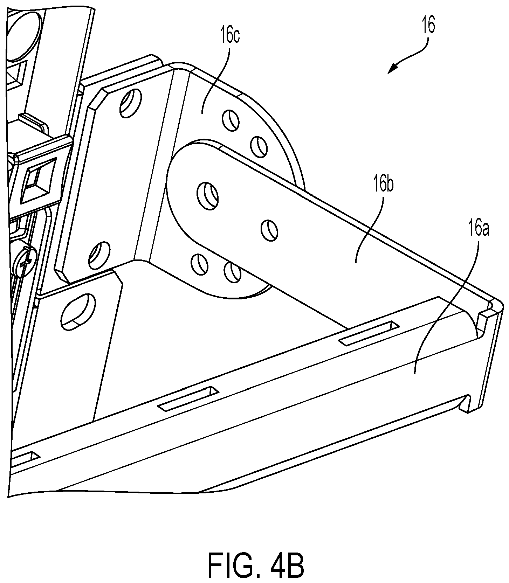

FIG. 3 illustrates an arrangement of a cable carriers 16 for routing and mounting cables with respect to a plurality of power systems, and FIG. 4 illustrates an exploded view of the cable carrier 16 in accordance with an embodiment of the present disclosure.

The plurality of power systems is stacked and mounted one above another by means of at least one mounting means 12. The mounting means 12 may be provided with a flange portion which extend from an operative end of the mounting means 12. The flange portion of the mounting means 12 is provided with atleast a pair of holes.

In an embodiment, the mounting means is selected from a group of brackets 16c consisting of metal bracket 16c or a fiber reinforced plastic bracket 16c or any combination thereof.

As is generally illustrated in FIG. 4a, the cable carrier 16 may comprise: a frame 16a portion with a pair of leg 16b, and a pair of brackets 16c. Each of the leg 16b extends transversely from either of extreme end of the frame 16a to define a U-shaped configuration. Also, each of the bracket 16c may be configured to be mounted on an operative portion of the leg 16b. An operative portion of the bracket 16c may be configured to be mounted on the flange to route and mount the cable thereon.

In an embodiment, an inner operative surface of the frame 16a and legs 16b may be configured with a channel to guide the cables 24 therethrough.

In an embodiment, the inner operative surface of the frame 16a and legs 16b may be configured with a plurality of clips to hold the different cables thereon.

In an embodiment, the frame 16a holds the different cables 24 by means of a plurality of sealing tags. Thereby, the frame 16a carries the different cables 24 thereon.

In an embodiment, each of the brackets 16c may be configured with a first set of holes 16d, a second set of holes 16e and a third hole 16f

In an embodiment, each of the legs 16b may be configured with a fourth hole 16g. Thefourth hole 16g of the leg 16b coincides with the third hole 16f of the bracket 16cto receive a fastening means therein. Thus, the frame 16a swivels around a common axis of the bracket 16c in an operative configuration so as adjust the angular displacement of the frame. FIG.4b illustrates an arrangement for swiveling of frame of the cable carrier in accordance with an embodiment of the present disclosure.

In an embodiment, each of the legs 16b may be configured with a set of fifth set of holes 16h. The frame may be configured to pivotally mounted on the operative portion of the bracket. Therefore, in a swiveling or pivot configuration of the frame 16a, at least one of the fifth set of holes 16h coincides with the at least one first set of holes 16d to enable locking of the frame 16a at any desired angle or in swiveling configuration. Thus, it facilitates ease of removal and insertion of the electronic component 22 to or from the power system 10. Therefore, the removal of the frame 16a or the cable carrier 16 may not be required during the removal or insertion of the electronic component 22 to or from the power system 10. Advantageously, the cable carrier 16 of the present disclosure thus avoids bending or kinking of the cable 24 and thus, it prolongs the cablelife.

In an embodiment, the locking of the frame 16a at any desired angle over the bracket 16c may be performed by means of a locking pin. The locking pin is inserted through the first set of hole 16d of the bracket to pass through the fifth set of hole 16h of the leg of the frame.

In an embodiment, the frame 16a may be configured to swivel either upward or downward around an axis of the bracket 16c.

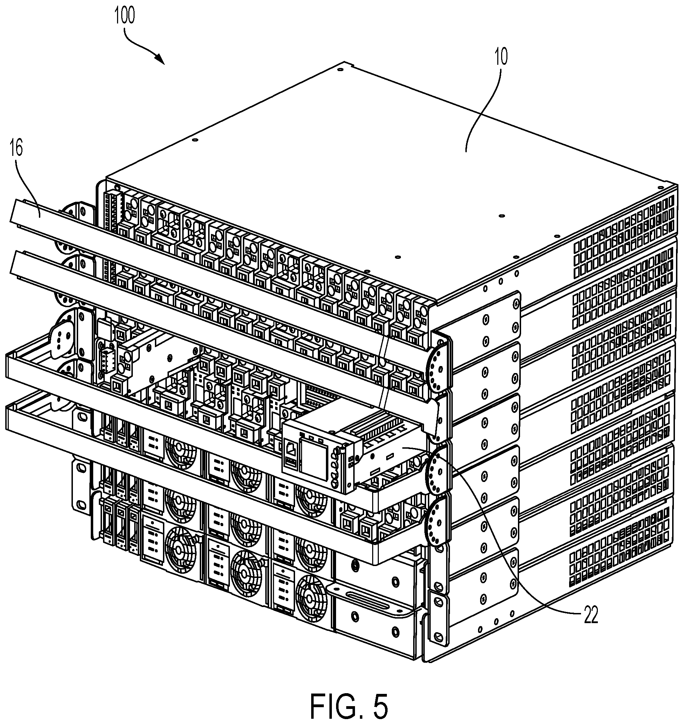

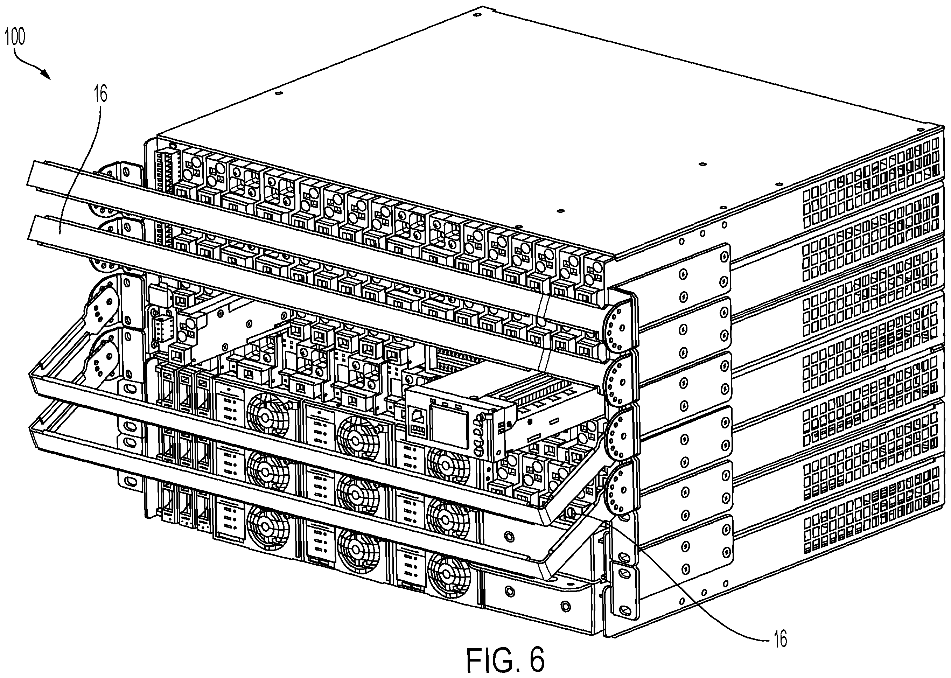

Advantageously, the swiveling action of the frame 16a of the cable carrier 16 enable the assembling or disassembling of the electronic component or controller or any other system device without dismantling the cable carrier 16 from the power system 10. Therefore, the cable carrier 16 of the present disclosure reduces the assembling and disassembling time of at least one electronic component on the power system and thus, it simplifies maintenance and enhance serviceability. FIG. 5 illustrates the upward swiveling of the frame of the cable carrier while assembling or disassembling the electronic component within the cabinet of the power. FIG. 6 illustrates the upward and downward swiveling of the frame of the cable carrier while assembling or disassembling the at least one electronic component within the cabinet of the power system in accordance with an embodiment of the present disclosure.

In an embodiment, the inner operative surface of the frame 16a and the legs 16b are provided with the channel to guide the different cables thereon.

In an embodiment, the cable carrier 16 may be selected from a group of material consisting of mild steel or Iron or any class of carbon or allowed steel. In an embodiment, the cable carrier 16 may be made of a polymeric material or a composite or any combination thereof.

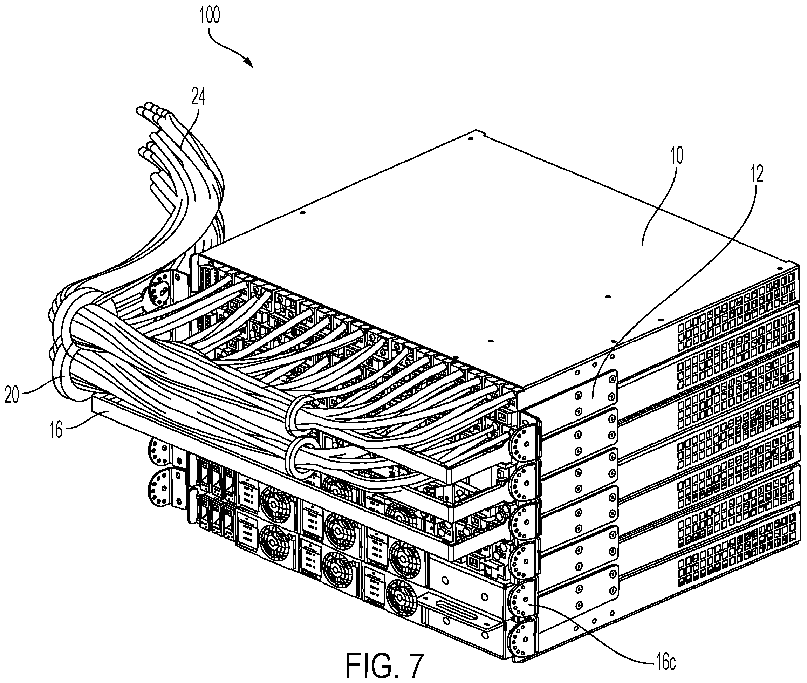

Advantageously, the cable carrier 16 of the present disclosure thus effectively routes and mount the different cables 24 by planning an environment that can address current as well as future and varying requirements. FIG. 7 illustrates the routing and mounting of cables on the frame of the cable carrier in accordance with an embodiment of the present disclosure.

The foregoing description of the embodiments has been provided for purposes of illustration and not intended to limit the scope of the present disclosure. Individual components of a particular embodiment are generally not limited to that particular embodiment, but, are interchangeable. Such variations are not to be regarded as a departure from the present disclosure, and all such modifications are considered to be within the scope of the present disclosure.

The foregoing disclosure has been described with reference to the accompanying embodiments which do not limit the scope and ambit of the disclosure. The description provided is purely by way of example and illustration.

The embodiments herein and the various features and advantageous details thereof are explained with reference to the non-limiting embodiments in the following description. Descriptions of well-known components and processing techniques are omitted so as to not unnecessarily obscure the embodiments herein. The examples used herein are intended merely to facilitate an understanding of ways in which the embodiments herein may be practiced and to further enable those of skill in the art to practice the embodimentsherein. Accordingly, the examples should not be construed as limiting the scope of the embodiments herein.

The foregoing description of the specific embodiments so fully reveal the general natureof the embodiments herein that others can, by applying current knowledge, readily modify and/or adapt for various applications such specific embodiments without departing from the generic concept, and, therefore, such adaptations and modifications should and are intended to be comprehended within the meaning and range of equivalents of the disclosed embodiments. It is to be understood that the phraseology or terminology employed herein is for the purpose of description and not of limitation. Therefore, while the embodiments herein have been described in terms of preferred embodiments, those skilled in the art will recognize that the embodiments herein can be practiced with modification within the spirit and scope of the embodiments as described herein.

Any discussion of devices, articles or the like that has been included in this specification is solely for the purpose of providing a context for the disclosure. It is not to be taken as an admission that any or all of these matters form a part of the prior art base or were common general knowledge in the field relevant to the disclosure as it existed anywhere before the priority date of this application.

While considerable emphasis has been placed herein on the components and component parts of the preferred embodiments, it will be appreciated that many embodiments can bemade and that many changes can be made in the preferred embodiments without departingfrom the principles of the disclosure. These and other changes in the preferred embodiment as well as other embodiments of the disclosure will be apparent to those skilled in the art from the disclosure herein, whereby it is to be distinctly understood that the foregoing descriptive matter is to be interpreted merely as illustrative of the disclosure and not as a limitation.

The disclosure comprises the following items:
1. A cable carrier comprising:
   a frame;
   a first leg extending from a first end of the frame;
   a second leg extending from a second end of the frame opposite the first end;
   a first bracket mounted on a first flange of the first leg; and
   a second bracket mounted on a second flange of the second leg, wherein a first surface of the frame includes at least one channel configured to guide at least one cable.
2. The cable carrier of item 1, wherein the first leg extends in a first direction from the first end.
3. The cable carrier of item 1 or item 2, wherein the second leg extends in the first direction from the second end.
4. The cable carrier of any preceding item, wherein the first leg, the second leg, and the frame define a u-shaped configuration.
5. The cable carrier of any preceding item, wherein the first surface of the frame includes a plurality of clips disposed thereon, the plurality of clips being configured to retain at least the at least one cable.
6. The cable carrier of any preceding item, wherein a first surface of the first leg includes at least one channel configured to guide at least one of the at least one cable or at least one other cable.
7. The cable carrier of any preceding item, wherein the first surface of the first leg is adjacent to the first surface of the frame.
8. The cable carrier of any preceding item, wherein the first surface of the first leg includes a plurality of clips disposed thereon, the plurality of clips being configured to retain at least one of the at least one cable and the at least one other cable.
9. The cable carrier of any preceding item, wherein a first surface of the second leg includes at least one channel configured to guide at least one of the at least one cable or at least one other cable.
10. The cable carrier of any preceding item, wherein the first surface of the second leg is adjacent to the first surface of the frame and faces the first surface of the first leg.
11. The cable carrier of any preceding item, wherein the first surface of the second leg includes a plurality of clips disposed thereon, the plurality of clips being configured to retain at least one of the at least one cable and the at least one other cable.
12. The cable carrier of any preceding item, wherein the frame is configured to pivot about a common axis of the first bracket and the second bracket.
13. The cable carrier of any preceding item, wherein the frame is configured to lock at an angle relative to the first bracket and the second bracket.
14. An apparatus comprising:
   a frame;
   at least one leg extending from an end of the frame; and
   at least one bracket mounted on a flange of the at least one leg, wherein a first surface of the frame includes at least one channel configured to guide at least one cable.
15. The apparatus of item 14, wherein the first surface of the frame includes a plurality of clips disposed thereon, the plurality of clips being configured to retain at least the at least one cable.
16. The apparatus of item 14 or 15, wherein a first surface of the at least one leg includes at least one channel configured to guide at least one of the at least one cable or at least one other cable.
17. The apparatus of any of items 14-16, wherein the first surface of the at least one leg is adjacent to the first surface of the frame.
18. The apparatus of any of items 14-17, wherein the first surface of the at least one leg includes a plurality of clips disposed thereon, the plurality of clips being configured to retain at least one of the at least one cable and the at least one other cable.
19. The apparatus of any of items 14-18, wherein the frame is configured to pivot about a common axis of the at least one bracket.
20. The apparatus of any of items 14-19, wherein the frame is configured to lock at an angle relative to the at least one bracket.

## Claims

1. A cable carrier comprising:
a frame;
a first leg extending from a first end of the frame;
a second leg extending from a second end of the frame opposite the first end;
a first bracket mounted on a first flange of the first leg; and
a second bracket mounted on a second flange of the second leg, wherein a first surface of the frame includes at least one channel configured to guide at least one cable.

2. The cable carrier of claim 1, wherein the first leg extends in a first direction from the first end.

3. The cable carrier of claim 2, wherein the second leg extends in the first direction from the second end.

4. The cable carrier of any preceding claim, wherein the first leg, the second leg, and the frame define a u-shaped configuration.

5. The cable carrier of any preceding claim, wherein the first surface of the frame includes a plurality of clips disposed thereon, the plurality of clips being configured to retain at least the at least one cable.

6. The cable carrier of any preceding claim, wherein a first surface of the first leg includes at least one channel configured to guide at least one of the at least one cable or at least one other cable.

7. The cable carrier of claim 6, wherein the first surface of the first leg is adjacent to the first surface of the frame.

8. The cable carrier of claim 6 or claim 7, wherein the first surface of the first leg includes a plurality of clips disposed thereon, the plurality of clips being configured to retain at least one of the at least one cable and the at least one other cable.

9. The cable carrier of any preceding claim, wherein a first surface of the second leg includes at least one channel configured to guide at least one of the at least one cable or at least one other cable.

10. The cable carrier of claim 9, wherein the first surface of the second leg is adjacent to the first surface of the frame and faces the first surface of the first leg.

11. The cable carrier of claim 9 or claim 10, wherein the first surface of the second leg includes a plurality of clips disposed thereon, the plurality of clips being configured to retain at least one of the at least one cable and the at least one other cable.

12. The cable carrier of any preceding claim, wherein the frame is configured to pivot about a common axis of the first bracket and the second bracket.

13. The cable carrier of any preceding claim, wherein the frame is configured to lock at an angle relative to the first bracket and the second bracket.

14. An apparatus comprising:
a frame;
at least one leg extending from an end of the frame; and
at least one bracket mounted on a flange of the at least one leg, wherein a first surface of the frame includes at least one channel configured to guide at least one cable.

15. The apparatus of claim 14, wherein:
the first surface of the frame includes a plurality of clips disposed thereon, the plurality of clips being configured to retain at least the at least one cable;
a first surface of the at least one leg includes at least one channel configured to guide at least one of the at least one cable or at least one other cable, and optionally wherein the first surface of the at least one leg is adjacent to the first surface of the frame and/or the first surface of the at least one leg includes a plurality of clips disposed thereon, the plurality of clips being configured to retain at least one of the at least one cable and the at least one other cable;
the frame is configured to pivot about a common axis of the at least one bracket; and/or the frame is configured to lock at an angle relative to the at least one bracket.
